# EUROPÄISCHE PATENTSCHRIFT

(11) **EP 0 305 698 B1**
(45) Veröffentlichungstag und Bekanntmachung des Hinweises auf die Patenterteilung: **09.06.1993**
(21) Anmeldenummer: 88111261.9
(22) Anmeldetag: 13.07.1988
(51) Int. Cl.: H05K 13/04, H05K 3/34

(54) **Dosiervorrichtung zum Aufbringen einer Lotpaste auf eine Leiterplatte für das Einlöten von SMD-Bauteilen**
Dosage device for the coating of a printed circuit board by a soldering paste for the soldering of SMD-components
Dispositif de dosage pour couvrir une plaque à circuits imprimés d'une pâte à souder pour le soudage de composants à montage sur une surface

(30) Priorität: 31.08.1987 DE 3729043
(43) Veröffentlichungstag der Anmeldung: 08.03.1989
(73) Patentinhaber: SIEMENS AKTIENGESELLSCHAFT, 80333 München (DE)
(72) Erfinder: Bunz, Georg, D-8000 München 70 (DE)

(56) Entgegenhaltungen:
- US-A- 3 912 153

## Beschreibung

Die Erfindung betrifft eine Dosiervorrichtung zum Aufbringen einer Lotpaste auf eine Leiterplatte, auf die Bauteile der SMD-Technik eingelötet werden.

Bei der Fertigung von elektronischen Flachbaugruppen ist in der letzten Zeit ein Übergang von der herkömmlichen Technik der Einsteckmontage zur Technik der Oberflächenmontage von flach auflötbaren Bauelementen zu verzeichnen. Die hierbei eingesetzten oberflächenmontierbaren Bauelemente (SMD ≙ Surface Mounted Devices) werden durch Bestückautomaten auf den Leiterplatten positioniert, meistens mittels mehrerer Klebstoffpunkte fixiert und anschließend durch ein übliches Lötverfahren verlötet, womit die elektrische Verbindung hergestellt ist. Die bei derartigen Verfahren auftretenden Fehler, sei es durch Einbau falscher oder defekter Bauelemente oder zum Beispiel durch falsche Positionierung, müssen in einem seperaten Verfahren durch Auslöten der entsprechenden Bauelemente und entsprechender Korrektur durch fehlerfreies Einlöten von neuen Bauelementen beseitigt werden. Dies geschieht mittels Vorrichtungen, die man im allgemeinen als Ein- und Auslötmaschinen bezeichnet. Derartige auf dem Markt erhältiche Maschinen müssen einer Vielzahl von Qualitätsanforderungen genügen. So ist es erforderlich, daß der Platz eines defekten Bauelementes, welches ausgelötet und durch fehlerfreies Einlöten eines funktionsfähigen Bauelementes ersetzt werden soll, ohne Behinderungen und ohne Parallaxen-Fehler zu betrachten ist. Des weiteren muß die Heizeinrichtung, mit der die Anschlußbeine des Bauelementes zum Aus- oder Einlöten beheizt werden, eine gleichmäßige Temperaturverteilung über die verschiedenen Anschlußbeine aufweisen und darf zugleich den Körper des Bauelementes nicht zu sehr erhitzen. Ebenso werden hohe Anforderungen an die Ausrichtung des Bauelementes bezüglich der Leiterplatte und des Lötplatzes, an die exakte Dosierung von Lotpaste, an die Kühlung des Bauelementes nach dem Einlöten, sowie an die Handhabung eines durch den Bestückautomaten aufgeklebten Bauelementes beim Auslöten in der Ein- oder Auslötmaschine gestellt.

Zur gleichmäßigen Einlötung eines SMD-Bauteiles, das meist eine Vielzahl von Anschlußbeinen aufweist, ist es notwendig die Dosierung der Lotpaste so exakt wie möglich vorzunehmen. Da es bei den Dimensionen der Anschlußbeine sowie deren Anschlußflecken auf der Leiterplatte notwendig ist, den Einlötvorgang mittels eines Mikroskopes zu beobachten, ist eine rein manuelle Aufbringung von Lotpaste nicht ausreichend.

Der Erfindung liegt die Aufgabe zugrunde, eine Dosiervorrichtung zum Aufbringen von Lotpaste für eine Ein- oder Auslötmaschine bereitzustellen, die ein exaktes Positionieren der Lotpastenaufbringung auf den entsprechenden Anschlußflecken auf der Leiterplatte, sowie eine exakte Dosierung der Lotpaste ermöglicht.

Die Lösung dieser Aufgabe wird durch den kennzeichnenden Teil des Anspruchs 1 beschrieben.

Bei der Kombination einer Ein- und Auslötmaschine mit einer Dosiervorrichtung für Lotpaste ist es zweckmäßig, die Dosiervorrichtung derart zu befestigen, daß der Dosiervorgang mit der Dosiervorrichtung ebenso wie der Ein- oder Auslötvorgang mit dem Lötkopf durch das an der Maschine angebrachte Mikroskop beobachtet werden kann. Die dosierte Aufbringung von Lotpaste auf die Anschlußflecken der Leiterplatte kann hierbei je nach konstruktiver Ausführung des Lötkopfes bei in seine Arbeitsstellung eingeschwenktem oder auch ausgeschwenktem Lötkopf geschehen. Der Lötkopf ist in seiner Arbeitsstellung, wenn er sich senkrecht über dem Einlötplatz befindet und der Einlötplatz vom Mikroskop aus senkrecht durch den Lötkopf hindurch zu betrachten ist. Die erfindungsgemäße Dosiervorrichtung, die in einem spitzen Winkel zu Leiterplatte bzw. zur Betrachtungsrichtung des Mikroskopes angestellt ist, ragt beim Dosiervorgang mit einer Dosiernadel bis in den Betrachtungsbereich des Mikroskopes hinein. Da sich die Dosiernadel genauso wie der Lötkopf relativ zu Leiterplatte und Bauelement in allen drei Koordinatenrichtungen bewegen läßt, ist somit eine Positionierung über den Anschlußflecken auf der Leiterplatte unter optischer Kontrolle mittels des Mikroskopes möglich.

Eine besonders vorteilhafte Ausgestaltung der Erfindung besteht darin, daß zur Vereinfachung der Konstruktion der Strahlengang des Mikroskopes durch ein Fenster innerhalb der Aufhängung der Dosiervorrichtung senkrecht nach unten gerichtet ist.

Da die Hubbewegung der Dosiervorrichtung über einen mit Druckluft gesteuerten Hubzylinder betätigt wird, ist die Dosiervorrichtung mit einem Anschlagstift ausgerüstet, der ähnliche Länge wie die Dosiernadel hat und in geringem Abstand parallel zu dieser befestigt ist. Durch diese Maßnahme wird eine Beschädigung der Dosiernadel durch Aufsetzen auf der Leiterplatte verhindert.

Im folgenden wird anhand der schematischen Figuren ein Ausführungsbeispiel beschrieben.
- Fig. 1: zeigt eine Ein- oder Auslötmaschine für SMD-Bauelemente 13 auf einer Leiterplatte 3,
- Fig. 2: zeigt eine Dosiervorrichtung 4 in Arbeitsstellung relativ zu einer Leiterplatte 3 angeordnet.

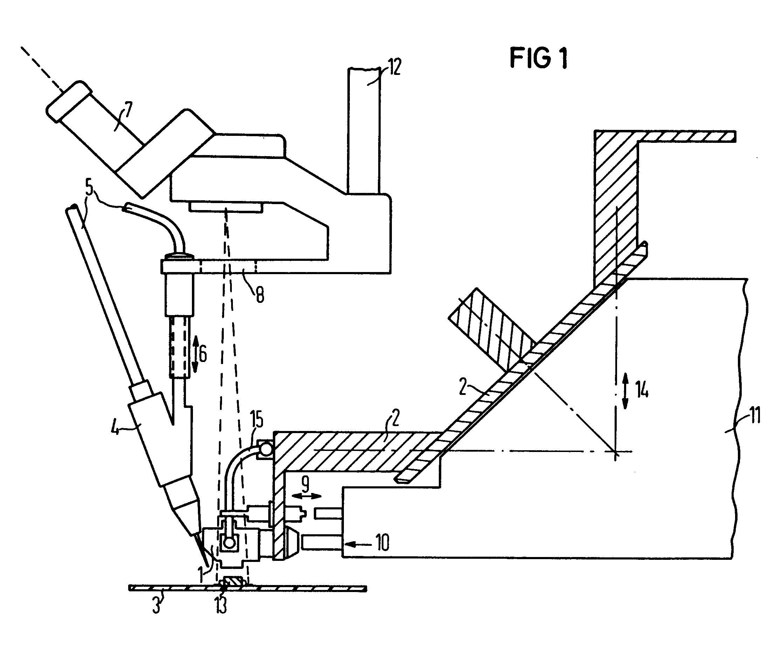

In Fig. 1 ist schematisch eine Ein- oder Auslötmaschine dargestellt. Sie enthält folgende wesentlichen Teile:
- den Lötkopf 1
- den Drehteller 2
- den Leiterplatte 3
- ein SMD-Bauelement 13
- eine Dosiervorrichtung 4 für Lotpaste mit
- Druckluftanschluß 5 und
- Hubzylinder 6, sowie
- Sichtfenster 8
- eine Optik 7, hier ein Mikroskop
- ein Stativ 12 für die Optik 7 und Dosiervorrichtung 4
- ein Stativ 11 für den Drehteller 2 mit
- einer Hubeinrichtung 14
- eine Vakuumleitung 15
- einen Hubzylinder 9
- eine Heißgaszuführung 10.

Der am Drehteller 2 über einen Auslegearm befestigte Lötkopf 1 ist in seiner Arbeitsstellung derart positioniert und arretiert, daß mittels der Optik 7 das SMD-Bauelement 13 von oben durch das Sichtfenster 8 und durch den Lötkopf hindurch betrachtet werden kann. Durch Drehen des Drehtellers 2 können verschiedene an ihm über Auslegearme befestigte Lötköpfe bereit gestellt und in Arbeitsposition geschwenkt werden. Dargestellt ist lediglich ein zweiter Auslegearm, der jedoch nicht mit einem Lötkopf 1 versehen ist. Zum Ein- oder Auslöten wird über die Heißgaszuführung 10 dem Lötkopf 1 ein Heißgas zugeführt, daß im Lötkopf 1 auf die Anschlußbeine des SMD-Bauteils 13 geleitet wird und diese auf die nötige Löttemperatur von beispielsweise 210° oder 225° erhitzt. Über den Hubzylinder 9 werden die im Lötkopf 1 enthaltenen Zentrierbacken betätigt, die das SMD-Bauelement 13 zeitweise zentrieren und festhalten. Eine weitere Halterung des SMD-Bauelementes 13 am Lötkopf 1 ist durch eine Vakuumeinrichtung gegeben, die über eine Vakuumleitung 15 versorgt wird. Die exakte Positionierung des Lötkopfes 1 relativ zu dem SMD-Bauelement 13 geschieht zum einen durch die in x/y-Richtung mögliche Verschiebung der Leiterplatte 3, sowie über die Hubeinrichtung 14, die den Lötkopf bezüglich der Höhe einstellt. Die Dosiervorrichtung 4 wird über die Druckluftanschlüsse 5 versorgt und durch den Hubzylinder 6 zum Aufbringen einer genau dosierten Menge von Lotpaste auf die Leiterplatte senkrecht nach oben oder nach unten bewegt. Auch hier ermöglicht die Optik 7 zusammen mit der senkrechten Betrachtungsweise durch den Lötkopf 1 hindurch eine parallaxenfreie Betrachung des Ein- oder Auslötplatzes. Hierzu sind durch die Optik 7 in der Regel nur die Anschlußbeine des SMD-Bauteiles 13 sichtbar. Der zentral sitzende Körper des SMD-Bauteiles 13 ist durch die Vakuumeinrichtung verdeckt, die das Bauteil zeitweise hält.

Eine derartige Ein- oder Auslötmaschine für SMD-Bauteile 13 ist durch den Einsatz von Computerprogrammen automatisierbar. Hierzu sind drei wesentliche Arbeitsschritte zu benennen - das Auslöten, das Dosieren der Lotpaste, das Einlöten eines neuen SMD-Bauteiles.

Der Ablauf ist wie folgt:

### Auslöten

Über eine Grobjustierung wird der Lötkopf 1 ca. 20 mm über das SMD-Bauteil 13 gefahren und anschließend über eine Feinjustierung auf ca. 1 bis 2 mm angenähert und in x/y-Richtung ausgerichtet, so daß er direkt über dem Bauteil steht. Mittels des über den Lötkopf geführten Heißgases 10 werden die Anschlußbeine des SMD-Bauelementes 13 von Raumtemperatur mit einer Geschwindigkeit von etwa 1,5° C pro Sekunde bis auf ca. 200° C aufgeheizt. Anschließend wird der Lötkopf 1 auf das Bauelement 13 abgesetzt und das Vakuum eingeschaltet, wodurch das Bauelement am Lötkopf angesaugt und gehalten wird. Während des nun einsetzenden eigentlichen Auslötprozesses wird innerhalb von 5 bis 15 Sekunden die Temperatur von 200 bis 210° C oder beispielsweise 225° C erhöht und das Lot zum Fließen gebracht. Der Lötkopf hebt anschließend mit dem Bauelement ab. Die angegebenen Zahlenwerte beziehen sich auf den Einsatz einer üblichen Lotpaste.

### Dosieren

Bei in Arbeitsposition eingeschwenktem oder auch ausgeschwenktem Lötkopf 1 wird über die Dosiervorrichtung 4 eine exakt dosierte Menge Lötpaste auf die Anschlußflecken auf der Leiterplatte 3 aufgebracht. Dazu wird die Dosiervorrichtung 4 bis auf einen Abstand von ca. 1 bis 2 mm zur Leiterplatte 3 abgesenkt. Der Hubzylinder 6 sorgt für das Absenken einer Dosiernadel der Dosiervorrichtung 4. Die Menge der notwendigen Lotpaste kann über den Druck in der Druckluftzuführung 5, über die Zeit oder über den Durchmesser der Dosiernadel gesteuert werden.

### Einlöten

Das Einlöten geschieht in entsprechender Weise wie das Auslöten. Das SMD-Bauelement 13 wird von dem Lötkopf 1 aufgenommen, mittels Zentrierbacken zentriert und über ein Vakuum festgehalten. Die Zentrierbacken sind in diesem Zustand wieder gelöst. Nach einer Grobpositionierung erfolgt das Absenken auf die Leiterplatte und die Feinjustierung, wobei mit der Opitk 7 kontrolliert wird. Innerhalb der ersten Phase des Aufheizens wird wiederum mit einer Geschwindigkeit von ca. 1,5° C pro Sekunde bis auf ca. 200° C vorgeheizt und beispielsweise beim Einsatz einer handelsüblichen Lotpaste innerhalb von weiteren 5 bis 15 Sekunden auf ca. 225° C erhitzt. Die Halterung durch Ansaugen mittels Vakuum wird anschließend abgeschaltet, wobei gleichzeitig, um eine Nacherhitzung des Körpers der SMD-Bauteile 13 zu vermeiden, etwa 10 Sekunden lang kalte Luft direkt über die Vakuumleitung auf das SMD-Bauelement geblasen wird. Der Lötkopf 1 hebt nun ab und der Einlötvorgang ist beendet.

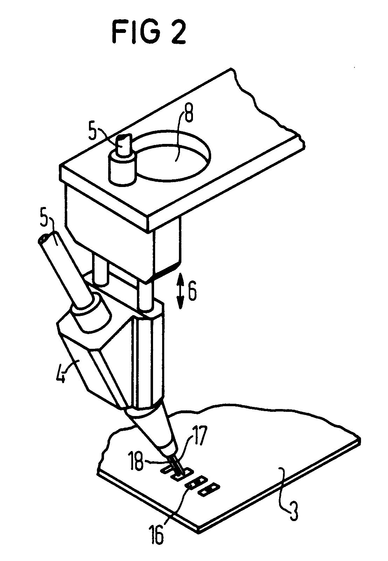

Die Fig. 2 zeigt eine Dosiervorrichtung 4, die über Druckluftanschlüsse 5 betätigt wird, eine Hubbewegung 6 über einen Hubzylinder ausführt und die Anschlußflecken 16 auf der Leiterplatte 3 exakt mit Lotpaste versieht. In der Halterung der Dosiervorrichtung ist ein Fenster 8 eingebaut, durch das die Anschlußflecken 16, sowie die Dosiernadel 17 und teilweise der Anschlagstift 18 senkrecht von oben sichtbar sind. Die Einstellung der Dosiervorrichtung 4 wird so vorgenommen, daß von einem bestimmten Abstand der Spitze der Dosiernadel 17 zur Leiterplatte 3 nach der Positionierung der Dosiernadel 17 über einem Anschlußfleck 16 der Anschlagstift 18 mittels eines Hubzylinders 6 auf einem Anschlußfleck 16 oder auf der Leiterplatte 3 aufsetzt und die Dosiernadel 17 über eine Druckluftsteuerung mittels der Druckluftanschlüsse 5 in Abhängigkeit von der Zeit und dem angelegten Druck eine bestimmte Menge an Lotpaste auf den Anschlußflecken 16 aufbringt.

Ein günstiger Bereich für die spitzwinkelige Anstellung der Dosiervorrichtung 4 bezüglich der senkrechten Betrachtungsrichtung liegt zwischen 15 und 30 Grad, wobei eine besonders gute Handhabung mit 20 Grad erreicht wird.

## Patentansprüche

1. Dosiervorrichtung (4) zum Aufbringen einer Lotpaste auf eine Leiterplatte (3) für das Einlöten von Bauelementen (13), insbesondere für oberflächenmontierbare Bauelemente (SMD),
**dadurch gekennzeichnet,**
daß die Achse der Dosiervorrichtung (4) mit der Leiterplatte (3) einen spitzen Winkel bildet und eine Dosiernadel (17) der Dosiervorrichtung (4) zumindest annähernd senkrecht von oben, am Ort der Einlötung, sichtbar ist.

2. Dosiervorrichtung (4) nach Anspruch 1,
**dadurch gekennzeichnet,**
daß die Dosiernadel (17) durch ein Fenster (8) innerhalb der Aufhängung der Dosiervorrichtung (4) sichtbar ist.

3. Dosiervorrichtung (4) nach einem der vorhergehenden Ansprüche, **dadurch gekennzeichnet,**
daß die Dosiervorrichtung (4) parallel zu der Dosiernadel (17) einen Anschlagsstift (18) aufweist.

## Claims

1. Metering device (4) for applying a solder paste to a printed-circuit board (3) for soldering in components (13), especially for surface-mounted components (SMD), characterised in that the axis of the metering device (4) forms an acute angle with the printed-circuit board (3) and a metering needle (17) of the metering device (4) is visible, at least approximately vertically from above, at the location of soldering in.

2. Metering device (4) according to Claim 1, characterized in that the metering needle (17) is visible through a window (8) inside the suspension of the metering device (4).

3. Metering device (4) according to one of the preceding claims, characterised in that the metering device (4) has a stop pin (18) parallel to the metering needle (17).

## Revendications

1. Dispositif de dosage (4) pour déposer und pâte de brasage sur une plaquette à circuits imprimés (3) pour le brasage de composants (13), notamment de composants pouvant être montés en surface (SMD), caractérisé par le fait que l'axe du dispositif de dosage (4) fait un angle aigu avec la plaquette à circuits imprimés (3) et qu'une aiguille de dosage (17) du dispositif de dosage (4) est visible à l'emplacement du brasage au moins approximativement perpendiculairement à partir du haut.

2. Dispositif de dosage (4) suivant la revendication 1, caractérisé par le fait que l'aiguille de dosage (17) est visible à travers une fenêtre (8) à l'intérieur du système de suspension du dispositif de dosage (4).

3. Dispositif de dosage (4) suivant l'une des revendications précédentes, caractérisé par le fait que le dispositif de dosage (4) possède une tige de butée (18) qui s'étend parallèlement à l'aiguille de dosage (17).
